# EUROPEAN PATENT APPLICATION

(11) **EP 4 498 642 A1**
(43) Date of publication of application: **29.01.2025**
(21) Application number: 24189540.8
(22) Date of filing: 18.07.2024
(51) Int. Cl.: H04L 12/40, G01R 31/52, H04L 41/0681

(54) **FAULT DETECTION SYSTEM, FAULT DETECTION METHOD AND CAN BUS DEVICE**

(30) Priority: 26.07.2023 CN 202310927916
(71) Applicant: Siemens Schweiz AG, 8047 Zürich (CH)
(72) Inventor: Zhao, Hai Fang, Xibeiwang,Haidian,Beijing City, 100094 (CN); Chen, Xue Yu, Xibeiwang,Haidian,Beijing City, 100094 (CN); Liang, Yun Feng, BSCE, Bei Jing, 100094 (CN); Chen, Li Guo, BEI JING, 100083 (CN); Zhang, Wei Hao, Jinzhou City, 052260 (CN)
(74) Representative: Siemens Patent Attorneys

(57) **Abstract**

Embodiments of the present application provide a fault detection system, a fault detection method and a CAN bus device. The fault detection system comprises: a first sampling module, which is connected between a CAN transceiver and a CAN controller, and is used for acquiring a sent logic signal and a received logic signal of the CAN transceiver, and, when the sent logic signal and the received logic signal both indicate that the CAN bus is in a dominant state, outputs a first enabling signal indicating a sampling result; a second sampling module, one end of the second sampling module being connected between a ground wire and the CAN bus, and the other end outputting a sampled voltage; a detection module, which is connected to the first sampling module and the second sampling module, and is used for detecting whether the sampled voltage matches a first reference voltage of the CAN bus in a recessive state in response to the first enabling signal; a fault judgment module, which is connected to the detection module, and is used for converting a detection result into a ground fault index of the CAN bus when the sampled voltage does not match the first reference voltage.

## Description

### Technical Field

Embodiments of the present application relate to the field of electronic circuits, particularly to a fault detection system, a fault detection method and a CAN bus device.

### Background Art

In long distance multi-node CAN bus industrial control, a ground fault of a CAN bus cable often occurs; in this situation, subsequent faults to these ground faults may lead to further misoperations of an onsite control device, and therefore it is necessary to detect such ground faults in a timely manner.

However, complex interference in the field of industrial control and electronic characteristics of CAN buses makes it difficult to find a reliable and efficient CAN bus ground fault detection solution.

### Summary of the Invention

In view of this, embodiments of the present application provide a fault detection system, a fault detection method and a CAN bus device, improving the efficiency and reliability of fault detection.

According to a first aspect of embodiments of the present application, a fault detection system is provided, comprising: a first sampling module, a second sampling module, a detection module and a fault judgment module. The first sampling module is connected between a CAN transceiver and a CAN controller, and is used for acquiring a sent logic signal and a received logic signal of the CAN transceiver, and, when the sent logic signal and the received logic signal both indicate that the CAN bus is in a dominant state, outputting a first enabling signal indicating a sampling result; one end of the second sampling module is connected between a ground wire and the CAN bus, and the other end outputs a sampled voltage; the detection module is connected to the first sampling module and the second sampling module, and is used for detecting whether the sampled voltage matches a first reference voltage of the CAN bus in a recessive state in response to the first enabling signal; the fault judgment module is connected to the detection module, and is used for converting a detection result into a ground fault index of the CAN bus when the sampled voltage does not match the first reference voltage.

It can be seen that, when the sent logic signal and the received logic signal both indicate that the CAN bus is in the dominant state, compared with being in the recessive state, the CAN transceiver is in a low impedance state, and an influence of the recessive state on a ground fault is eliminated as much as possible. Furthermore, when the CAN bus encounters a ground fault, a sampled voltage between the ground wire and the CAN bus is affected, presenting the reference voltage corresponding to the dominant state; therefore, when the CAN bus is in the dominant state, the detection module detects a mismatch with the first reference voltage of the CAN bus in the recessive state, and thus the fault judgment module can convert the detection result into a ground fault index of the CAN bus to reliably and efficiently perform ground fault judgment, thereby improving efficiency and reliability of fault detection.

In another embodiment of the present application, the first sampling module comprises an AND gate, a first input end and a second input end of the AND gate being respectively used for receiving the sent logic signal and the received logic signal, and when the sent logic signal and the received logic signal both indicate that the CAN bus is in the dominant state, the output end of the AND gate outputting a first enabling signal that indicates a sampling result. It can be seen that the output end of the AND gate outputs a first enabling signal that indicates a sampling result, so that the sent logic signal and the received logic signal of the CAN bus in the dominant state are sampled efficiently.

In another embodiment of the present application, when one of the sent logic signal and the received logic signal indicates that the CAN bus is in the recessive state, the output end of the AND gate outputs a second enabling signal, and the second enabling signal indicates that the detection module is prohibited from executing detection. It can be seen that the output end of the AND gate outputs a second enabling signal that indicates a sampling result, and logic signal sampling on the CAN transceiver in a high impedance state is avoided, improving reliability of sampling.

In another embodiment of the present application, the second sampling module comprises a first voltage division circuit, one end of the first voltage division circuit being connected between a ground wire and the CAN bus, the other end being connected to a high bias voltage, the first voltage division circuit outputting the sampled voltage, and a voltage division ratio of the first voltage division circuit being provided between the first reference voltage and the high bias voltage. It can be seen that a sampling process for sampling a voltage is achieved simply by means of the first voltage division circuit in the present example.

In another embodiment of the present application, the detection module comprises a transmission gate and a comparator, a control end of the transmission gate being connected to an output end of the first sampling module, an input end of the transmission gate being connected to an output end of the second sampling module, and used for receiving the sampled voltage, an output end of the transmission gate being connected to a first input end of the comparator, a second input end of the comparator receiving a tolerance threshold value of the first reference voltage, and an output end of the comparator being connected to the fault judgment module; when the control end receives the first enabling signal, the output end and the input end of the transmission gate are connected to each other. It can be seen that provision of the transmission gate simply achieves reliable control of timing of acquisition of the sampled voltage by the detection module, and provision of the comparator simply achieves high-precision voltage detection.

In another embodiment of the present application, the comparator comprises a first comparator and a second comparator; a first input end of the first comparator and a first input end of the second comparator are both connected to the output end of the transmission gate, for receiving the sampled voltage, a second input end of the first comparator receiving a tolerance upper limit threshold value of the first reference voltage, and a second input end of the second comparator receiving a tolerance lower limit threshold value of the first reference voltage; when the sampled voltage is greater than the tolerance upper limit threshold value, the output end of the first comparator outputs a first control signal, which indicates that the sampled voltage and the first reference voltage do not match, to the fault judgment module, or when the sampled voltage is less than the tolerance lower limit threshold value, the output end of the second comparator outputs a first control signal, which indicates that the sampled voltage and the first reference voltage do not match, to the fault judgment module. It can be seen that provision of the first comparator and the second comparator simply achieves a comparison process of the tolerance upper limit threshold value and the tolerance lower limit threshold value, respectively using the first comparator and the second comparator to perform reliable detection on two lines of the CAN bus.

In another embodiment of the present application, the CAN bus comprises a high-voltage line and a low-voltage line, the tolerance upper limit threshold value is less than a second reference voltage of the high-voltage line in the dominant state, and the tolerance lower limit threshold value is greater than a second reference voltage of the low-voltage line in the dominant state. It can be seen that the tolerance upper limit threshold value and the tolerance lower limit threshold value are set such that said range is advantageous for ensuring that a ground fault of the two lines of the CAN bus is detected accurately, avoiding missed detections.

In another embodiment of the present application, the fault judgment module comprises an integrator, one end of the integrator being connected to the output end of the first comparator, the output end of the second comparator and the CAN controller, and the other end of the integrator being connected to a high bias voltage; in a fault judgment period, the integrator performs integration at least according to a first current corresponding to the first control signal, to obtain a feedback voltage that indicates a ground fault index, the fault judgment period at least comprising a duration period of the first control signal. It can be seen that the integrator integrates the first control signal, and fault judgment is performed on the basis of an integration result, improving the accuracy and reliability of ground fault judgment, and reducing or preventing the possibility of a misjudgment.

In another embodiment of the present application, in the fault judgment period, the integrator performs integration according to the first current corresponding to the first control signal, and performs integration according to a second current corresponding to the second control signal, to obtain a feedback voltage that indicates a ground fault index, the fault judgment period at least comprising the duration period of the first control signal and a duration period of the second control signal. It can be seen that the process of integrating the second control signal is opposite to the process of integrating the first control signal; therefore, accumulated results of different scenarios in a fault judgment period are taken into account, further improving accuracy and reliability of ground fault judgment.

In another embodiment of the present application, the fault detection system further comprises: a driving module, which is connected to the CAN transceiver and is used for enhancing a driving current of the CAN transceiver; and a management module, which is connected to the detection system and is used for adjusting the tolerance threshold value according to the driving current. It can be seen that the driving module is used to enhance the driving current, increasing a signal-to-noise ratio of a voltage signal in the fault detection process, increasing precision and reliability in a fault detection process.

According to a second aspect of embodiments of the present application, a fault detection method is provided, comprising: acquiring a sent logic signal and a received logic signal of a CAN transceiver; when the sent logic signal and the received logic signal both indicate that the CAN bus is in a dominant state, detecting whether a sampled voltage between the ground wire and the CAN bus matches a first reference voltage of the CAN bus in the recessive state; and converting a detection result into a ground fault index of the CAN bus when the sampled voltage does not match the first reference voltage.

According to a third aspect of embodiments of the present application, a CAN bus device is provided, comprising: a CAN controller, a CAN transceiver, and the fault detection system according to the first aspect.

### Brief Description of the Drawings

To explain the technical solutions in embodiments of the present application or in the prior art more clearly, there follows a simple description of the accompanying drawings that need to be used in a description of embodiments or the prior art. Obviously, the drawings in the description below are merely some embodiments specified in embodiments of the present application, and a person skilled in the art could obtain other drawings based on these drawings.
Fig. 1 is a control architecture drawing of a CAN bus device according to an example.
Fig. 2 is a schematic block diagram of a fault detection system according to an embodiment of the present application.
Fig. 3 is a schematic circuit diagram of a fault detection system according to the embodiment of Fig. 2.
Fig. 4 is a timing diagram of relevant signals of a CAN bus device of the embodiment of Fig. 2.
Fig. 5 is a schematic block diagram of a CAN bus device according to another embodiment of the present application.
Fig. 6 is a flowchart of steps of a fault detection method of another embodiment of the present application.

Key to labels used in the drawings:
12: CAN bus device; 18: CAN high-voltage line; 20: CAN low-voltage line; 22: terminal resistor; 24: microprocessor; 25: CAN controller; 26: CAN transceiver;
200: fault detection system; 210: first sampling module; 220: second sampling module; 230: detection module; 240: fault judgment module; 600: fault detection method;
S610: Acquiring a sent logic signal and a received logic signal of a CAN transceiver;
S620: When the sent logic signal and the received logic signal both indicate that the CAN bus is in a dominant state, detecting whether a sampled voltage between a ground wire and the CAN bus matches a first reference voltage of the CAN bus in a recessive state;
S630: When the sampled voltage and the first reference voltage do not match, converting a detection result into a ground fault index of the CAN bus.

### Detailed Description of the Invention

To enable those skilled in the art to better understand the technical solution in the embodiments of the present application, the technical solution in the embodiments of the present application is described clearly and completely below with reference to the drawings in the embodiments of the present application. Obviously, the embodiments described are only some, not all, of the embodiments of the present application. All other embodiments obtained by those skilled in the art on the basis of embodiments in the embodiments of the present application should fall within the scope of protection of the embodiments of the present application.

Specific implementations of embodiments of the present application are explained further below in conjunction with accompanying drawings of embodiments of the present application.

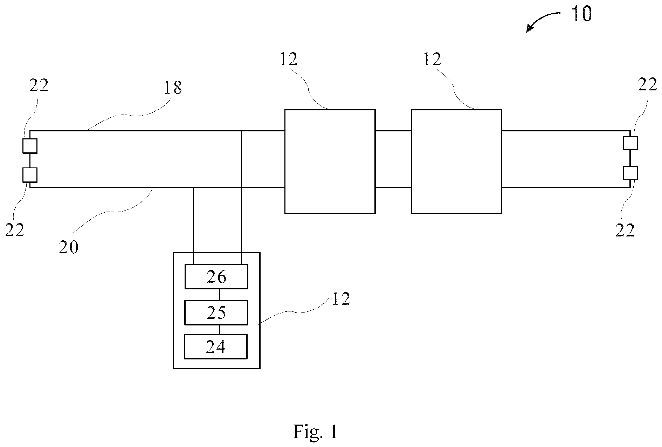

Fig. 1 shows a control architecture drawing of a CAN bus device according to an example. The control architecture drawing in the present example describes communication in the field of vehicles by way of example, but a person skilled in the art will understand that the field of vehicle communication is merely exemplary, and the concept disclosed herein may also be applied to any other suitable communication systems, such as universal industrial automotive applications and games, to name some. The term "vehicle" described herein also should be broadly understood to not only include passenger vehicles, but also any other means of transportation, including but not limited to motorcycles, trucks, sports utility vehicles (SUVs), recreational vehicles (RVs), boats and aircraft.

A controller area network (CAN) is a multi-master broadcast serial bus standard designed to allow a micro-controller and an apparatus to mutually communicate in the vehicle. The most common physical layer standard in a CAN protocol is a defined two-wire balanced signal scheme (called high speed CAN), used herein as an example. This standard designates a two-wire differential line, wherein the number of nodes is restricted by an electrical bus load. These two lines are determined to be CAN_H (i.e. a CAN high-voltage line) and CAN_L (i.e. a CAN low-voltage line). In an example, a line impedance is 120 Q, and a range of a common-mode voltage is from -2 V on CAN_L to +7 V on CAN_H. More specifically, a voltage on the CAN low-voltage line is generally in a range of 0.5 V to 2.5 V, and a voltage on the CAN high-voltage line is generally in a range of 2.5 V to 4.5 V. Each node (i.e. ECU) on the CAN bus can send and receive messages but not simultaneously. That is, the nodes perform half-duplex communication. The message comprises an ID that indicates a priority of the message. The mechanism is called priority-based bus arbitration. A message having an ID value that is numerically smaller has a higher priority than a larger ID value, and therefore is transmitted first.

Further, a CAN protocol further designates two logic states: a recessive state and a dominant state. A differential voltage is used for indicating recessive and dominant states (that is, bits). In the recessive state (logic 1), the differential voltage on CAN_H and CAN_L is less than a minimum threshold value. In the dominant state (logic 0), the differential voltage on CAN_H and CAN_L is greater than the minimum threshold value. Data in a CAN network is transmitted as information, and the information is more commonly called frames. Generally, a frame is separated from a previous frame by a bit field called an interframe gap, and the interframe gap consists of at least three consecutive recessive bits. After these consecutive recessive bits, if a dominant bit is detected, then this bit is regarded as the "frame start" bit of the next frame.

The system and method disclosed in the present application use two A/D converters to measure a voltage on CAN_H and CAN_L, and then use this voltage to detect and isolate a ground fault. More specifically, the disclosed method comprises: from the measured CAN bus voltage, determining a voltage in an interframe region and a mean voltage of a dominant bit in a frame, and then comparing this interframe voltage and intraframe voltage with a predetermined threshold value to detect and isolate a floating ground fault and a ground offset fault.

Referring to Fig. 1, an exemplary vehicle communication system 10 is shown. The system 10 comprises multiple CAN bus devices 12 (for example, ECUs) and a CAN bus connected to two wires. The two wires comprising the CAN bus are CAN_H (that is, a CAN high-voltage line) 18 and CAN_L (that is, a CAN low-voltage line) 20, and the two wires are terminated by terminal resistors 22 at each end. Although the values of the terminal resistors 22 may be different, an exemplary value may be 60 Q or, if split termination is not used, 120 Q.

As described above, the CAN is a bus standard designed to allow mutual communication between a micro-processor and an apparatus using a message-based protocol. Multiple CAN bus devices may be mounted in the CAN bus, and the CAN bus devices may be ECUs (electronic control units) . For example, in automobile applications, a vehicle may comprise as many as 80 ECUs to control various subsystems, and connections may be performed by means of multiple CAN bus systems. For simplicity, Fig. 1 only shows a CAN bus device 12; a person skilled in the art will understand that multiple configurations of CANs are known, and the configuration shown in Fig. 1 is exemplary and non-limiting.

Specifically, each ECU on the CAN basically comprises a processor or micro-processor 24, a CAN controller 25 and a CAN transceiver 26. The micro-processor 24 controls segmented transmission of messages and is connected to various sensors, an actuator and a control apparatus. The CAN controller 25 is generally a constituent part of the micro-processor, and is configured to store serial bits received from the CAN bus until the entire message is available, and then the micro-processor 24 may obtain this message. The CAN controller 25 is further configured to receive a message that is transmitted by the micro-processor, and then this message is transmitted serially as bits to the CAN bus 16. The CAN transceiver 26 converts a data stream from the CAN bus into a processable level for the CAN controller 25. The CAN transceiver 26 further may comprise a circuit for protecting the CAN controller 25.

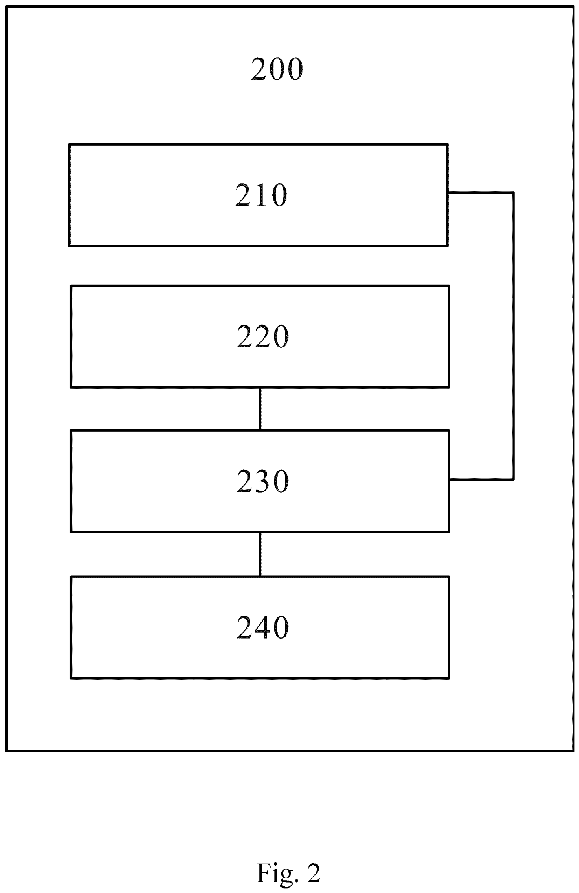

A fault detection system 200 according to an embodiment of the present application is described below in conjunction with Fig. 2. The fault detection system 200 comprises a first sampling module 210, a second sampling module 220, a detection module 230 and a fault judgment module 240.

Specifically, the first sampling module 210 is connected between a CAN transceiver and a CAN controller, and is used for acquiring a sent logic signal and a received logic signal of the CAN transceiver, and when the sent logic signal and the received logic signal both indicate that a CAN bus is in a dominant state, outputting a first enabling signal that indicates a sampling result. Generally, the first sampling module 210 may be a digital circuit such as a logic gate; the logic gate may detect level states of a sent logic signal and a received logic signal, and based on said level states, judge a level state when the sent logic signal and the received logic signal both indicate that the CAN bus is in the dominant state, and the logic gate outputs a first enabling signal according to when the sent logic signal and the received logic signal satisfy such a level state. In addition, when the sent logic signal and the received logic signal satisfy such a level state, a second enabling signal, which is different to the first enabling signal, is output. For example, the logic gate may be an AND gate.

In addition, one end of the second sampling module 220 is connected between a ground wire and the CAN bus, and the other end outputs a sampled voltage. The second sampling module may comprise a first voltage division circuit that is arranged between a high bias voltage and a low bias voltage, and a voltage division ratio of the first voltage division circuit is determined by means of a first reference voltage and a difference between the high bias voltage and the low bias voltage. Generally, the second sampling module may be an analog detection circuit; when an input voltage of the analog detection circuit changes, an output voltage also changes, so that a changed sampled voltage is output when the CAN bus is detected as being grounded. The analog detection circuit may be the first voltage division circuit.

In addition, the detection module 230 is connected to the first sampling module 210 and the second sampling module 220, and used for detecting whether the sampled voltage matches the first reference voltage of the CAN bus in a recessive state in response to the first enabling signal. Generally, the detection module 230 may be a comparison circuit such as a comparator and a control circuit; the comparison circuit is used for determining by comparison a relationship between magnitudes of the sampled voltage and the first reference voltage, and the control circuit is used for controlling, in response to the first enabling signal or the second enabling signal, the timing of comparison processing performed by the comparison circuit, so as to output a detection result of a mismatch between the sampled voltage and the first reference voltage.

In addition, the fault judgment module 240 is connected to the detection module 230, and used for converting a detection result into a ground fault index of the CAN bus when the sampled voltage and the first reference voltage do not match. Generally, the fault judgment module may be an analog circuit or a digital circuit, that is, the detection result is digitally processed using a digital circuit, or the detection result is processed non-linearly using an analog circuit, to obtain a ground fault index.

Furthermore, the fault judgment module 240 may feed the ground fault index back to the CAN controller 25. The CAN controller 25 may be, for example, a digital circuit of a micro-controller, used for executing a ground fault judgment on the basis of the ground fault index, for example, comparing the ground fault index with a ground fault index threshold value. The ground fault index threshold value may be determined on the basis of an empirical value or a historical ground fault index.

In an embodiment according to the present application, when a sent logic signal and a received logic signal both indicate that a CAN bus is in a dominant state, compared with being in a recessive state, the CAN transceiver is in a low impedance state, and an influence of the recessive state on a ground fault is eliminated as much as possible. Furthermore, when the CAN bus encounters a ground fault, a sampled voltage between the ground wire and the CAN bus is affected, presenting the reference voltage corresponding to the dominant state; therefore, when the CAN bus is in the dominant state, the detection module detects a mismatch with a first reference voltage of the CAN bus in the recessive state, and thus the fault judgment module can convert the detection result into a ground fault index of the CAN bus to reliably and efficiently perform ground fault judgment, thereby improving efficiency and reliability of fault detection.

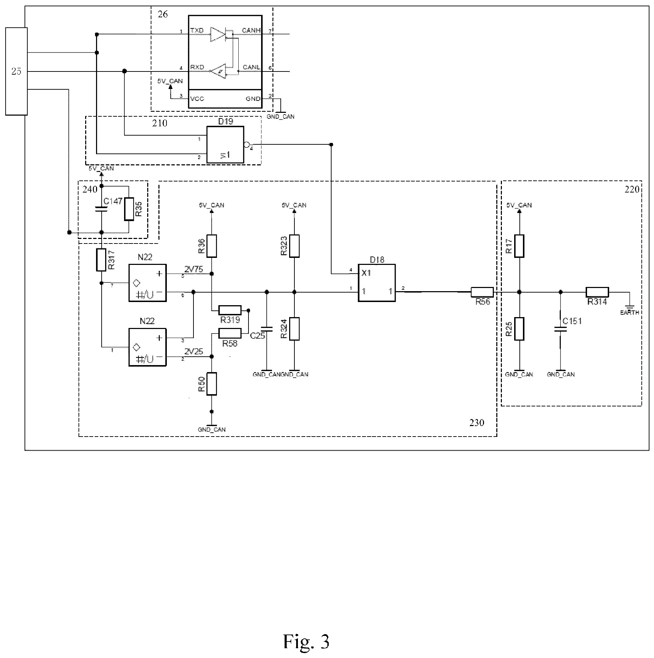

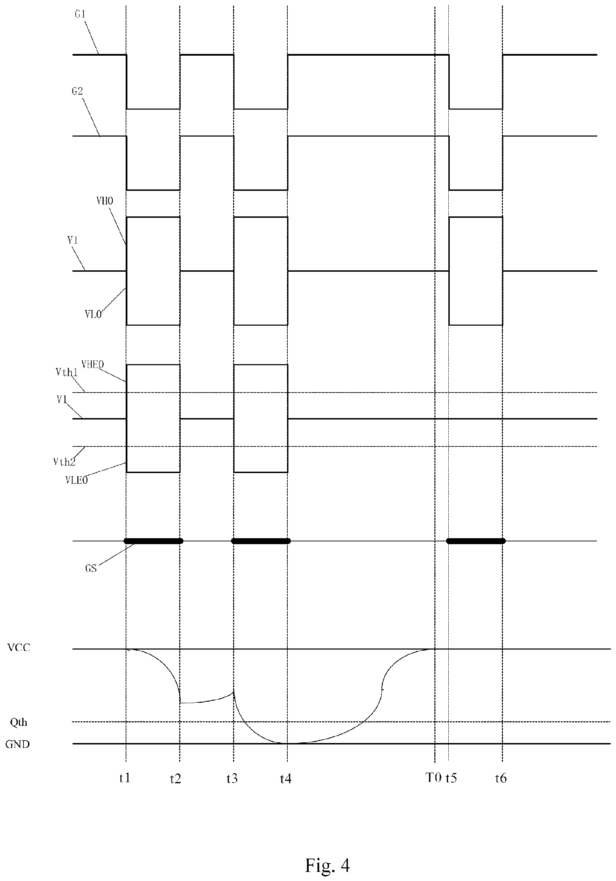

Functions and configurations of various modules of the fault detection system are described below in conjunction with Figs. 3 and 4.

Without loss of generality, the first sampling module 210 comprises an AND gate, a first input end and a second input end of the AND gate being respectively used for receiving the sent logic signal and the received logic signal, and when the sent logic signal and the received logic signal both indicate that the CAN bus is in the dominant state, the output end of the AND gate outputting a first enabling signal that indicates a sampling result, so that the sent logic signal and the received logic signal of the CAN bus in the dominant state are sampled efficiently.

Specifically, referring to Fig. 3, an AND gate D19 comprises an input end 1, an input end 2 and an output end 4. The input end 1 is connected to a receiving end of the CAN transceiver 26, and the input end 2 is connected to a sending end of the CAN transceiver 26. The receiving end is used for converting a differential voltage of the CAN bus into the received logic signal, and the sending end is used for converting the sent logic signal into a differential voltage of the CAN bus.

It should be understood that the receiving end and the sending end of the CAN transceiver 26 are also directly connected to the CAN controller 25 or are connected to the CAN controller 25 via a device such as an isolator.

Furthermore, the output end 4 of the AND gate D19 is connected to a control end 4 of a transmission gate D18; when the control end 4 inputs a first enabling signal, an output end 1 and an input end 2 of the transmission gate D18 are connected to each other. When the control end 4 inputs a second enabling signal, the output end 1 and the input end 2 of the transmission gate D18 are disconnected from each other.

In addition, without loss of generality, when one of the sent logic signal and the received logic signal indicates that the CAN bus is in a recessive state, the output end of the AND gate outputs a second enabling signal, and the second enabling signal indicates that the detection module 230 is prohibited from executing detection.

Specifically, when the sent logic signal and the received logic signal both indicate that the CAN bus is in a dominant state (corresponding to a low level 0), the output end 4 of the AND gate D19 outputs a first enabling signal. When at least one of the sent logic signal and the received logic signal indicates that the CAN bus is in a recessive state (corresponding to a high level 1), the output end 4 of the AND gate D19 outputs a second enabling signal.

Figure 4 shows a timing diagram of relevant signals of an embodiment of the present application. G1 indicates a sent logic signal, and G2 indicates a received logic signal; VH0 indicates a high voltage signal (such as 4.5 V) in a differential signal of CAN_H in a dominant state, and VL0 indicates a low voltage signal (such as 0.5 V) in a differential signal of CAN_L in a dominant state; and V1 indicates a differential signal (such as 2.5 V) of CAN_H and CAN_L in a recessive state.

Before time T0 is a period in which the CAN bus encounters a ground fault, and after time T0 is a period in which the CAN bus does not encounter a fault. As shown in Fig. 4, a first enabling signal indicated by the sampled signal GS corresponds to period t1 - t2, period t3 - t4 and period t5 - t6, and a second enabling signal corresponds to period t2 - t3 and t4 - t5.

If CAN_H encounters a ground fault, then VHE0 indicates that the detection module 230 detects a sampled voltage; if CAN_L encounters a ground fault, then VLE0 indicates that the detection module 230 detects a sampled voltage. A ground fault encountered by at least one of CAN_H and CAN_L is regarded as a ground fault of the CAN bus.

Furthermore, the input end 2 of the transmission gate D18 may be connected to an output end of a second sampling module 220; for example, the input end 2 of the transmission gate D18 is connected to an output end of a first voltage division circuit. The first voltage division circuit acts as an example of the second sampling module 220, comprising a resistor R17 and a resistor R25 connected in series, one end of the resistor R17 is connected to one end of the resistor R25, the other end of the resistor R17 is connected to a high bias voltage, and the other end of the resistor R25 is connected to a low bias voltage, so that the output end of the first voltage division circuit outputs a sampled voltage. Specifically, the input end 2 of the transmission gate D18 may be connected between the resistor R17 and the resistor R25, and one end of the resistor R17 connected to one end of the resistor R25 may be directly or indirectly grounded (such as by means of a resistor R314).

In the example of Fig. 3, the high bias voltage is 5 V, the low bias voltage is 0, a ratio of resistor R17 and resistor R25 is a voltage division ratio 1, and at this time, the input end 2 of the transmission gate D18 receives 2.5 V (that is, an example of a first reference voltage of a CAN bus in a recessive state).

Without loss of generality, the second sampling module 220 comprises a first voltage division circuit, one end of the first voltage division circuit being connected to a low bias voltage (for example, being grounded), the other end being connected to a high bias voltage, the first voltage division circuit (for example, from a connecting end between the resistor R17 and the resistor R25) outputting a sampled voltage, and a voltage division ratio of the first voltage division circuit being provided between the first reference voltage and the high bias voltage. That is, a sampling process for sampling a voltage is achieved simply by means of the first voltage division circuit; when the CAN bus encounters a ground fault, a sampled voltage received by the input end 2 of the transmission gate D18 may fluctuate relative to 2.5 V, for example, fluctuating toward a second reference voltage 4.5 V of the CAN_H line or a second reference voltage 0.5 V of the CAN_L line. In addition, the second sampling module 220 further comprises a capacitor C151, one end of the capacitor C1151 is connected to a low bias voltage (such as being grounded), and the other end of the capacitor C1151 is connected between the resistor R17 and the resistor R25.

Without loss of generality, the control end 4 of the transmission gate D18 is connected to the output end of the first sampling module, and the input end of the transmission gate is connected the output end of the second sampling module 220, used for receiving a sampled voltage.

Referring back to Fig. 3, the detection module 230 may comprise a comparator N22, the comparator N22 being coupled to the transmission gate D18. The output end 1 of the transmission gate D18 is connected to first input ends 3 and 6 of the comparator N22, and second input ends 2 and 5 of the comparator N22 receive a tolerance threshold value (such as 2.75 V or 2.25 V) of the first reference voltage (such as 2.5 V); output ends 1 and 7 of the comparator N22 are connected to the fault judgment module 240.

In addition, the fault detection system 200 further comprises a driving module and a management module. The driving module is connected to the CAN transceiver and is used for enhancing a driving current of the CAN transceiver. The management module is connected to the detection system and is used for adjusting the tolerance threshold value according to the driving current. That is, the driving current may be positively correlated with a tolerance threshold value; the larger the driving current, the greater the difference between a first reference voltage and a second reference voltage corresponding to a recessive state, and the larger the tolerance threshold value. As an example, when the driving current is larger, differential voltages on the CAN_H line and the CAN_L line may be 4.5 V and 0.5 V, and the corresponding tolerance threshold values may be set at 2.75 V and 2.25 V; when the driving current is larger, the differential voltages on the CAN_H line and the CAN_L line may be 3.5 V and 2.5 V, and the corresponding tolerance threshold values may be set at 2.65 V and 2.35 V.

Furthermore, the comparator N22 comprises a first comparator and a second comparator, and a first input end 6 of the first comparator and a first input end 3 of the second comparator are both connected to the output end 1 of the transmission gate D18, and used for receiving a sampled voltage.

A second input end 5 of the first comparator receives a tolerance upper limit threshold value (such as Vth1 = 2.75 V in Fig. 4) of the first reference voltage, and the second input end 2 of the second comparator receives a tolerance lower limit threshold value (such as Vth2 = 2.25 V in Fig. 4) of the first reference voltage.

When the sampled voltage is greater than the tolerance upper limit threshold value, the output end 7 of the first comparator outputs a first control signal, which indicates that the sampled voltage and the first reference voltage do not match, to the fault judgment module 240, or when the sampled voltage is less than the tolerance lower limit threshold value, the output end 1 of the second comparator outputs a first control signal, which indicates that the sampled voltage and the first reference voltage do not match, to the fault judgment module 240.

That is, the CAN bus comprises a high-voltage line and a low-voltage line, the tolerance upper limit threshold value is less than a second reference voltage (such as 4.5 V) of the high-voltage line in the dominant state, and the tolerance lower limit threshold value is greater than a second reference voltage (such as 0.5 V) of the low-voltage line in the dominant state.

Referring to Fig. 3, the tolerance upper limit threshold value and the tolerance lower limit threshold value may be generated by means of a voltage generation branch of the detection module 230, the voltage generation branch comprising resistors R36, R319, R58 and R50 connected in series, wherein R36 is connected to a high bias voltage, and R50 is connected to a low bias voltage (for example, being grounded). The second input end 5 of the first comparator is connected between R36 and R319, and the second input end 2 of the second comparator is connected between R58 and R50.

Furthermore, the detection module 230 further comprises a second voltage division circuit, one end of the second voltage division circuit being connected to a low bias voltage (for example, being grounded), and the other end being connected to a high bias voltage. A voltage division ratio of the first voltage division circuit is the same as a voltage division ratio of the second voltage division circuit. As shown in Fig. 3, the second voltage division circuit comprises a resistor R324 and a resistor R323, a ratio of R324 and R323 being the voltage division ratio of the second voltage division circuit. The first input end 6 of the first comparator and the first input end 3 of the second comparator are both connected between R324 and R323.

The detection module 230 further comprises a resistor R56 and a capacitor C25, the resistor R56 is connected between the output end of the first voltage division circuit and the input end 2 of the transmission gate D18, one end of the capacitor C25 is connected to the output end 1 of the transmission gate D18, and the other end of the capacitor C25 is connected to a low bias voltage (for example, being grounded).

It should be understood that an output impedance of the first voltage division circuit may be less than an input impedance of the second voltage division circuit; therefore, by means of the resistor R56 and the capacitor C25, a sampled voltage can reliably flow from the first voltage division circuit, via the second voltage division circuit, into the first input end 6 of the first comparator and the second input end 3 of the second comparator.

In the example of Fig. 3, two input ends of the AND gate D19 respectively receive a sent logic signal and a received logic signal; if the sent logic signal and the received logic signal indicate that the CAN bus is in the dominant state, then the output end of the AND gate D19 outputs a first enabling signal for an output end and an input end of the transmission gate D18 to be connected to each other; otherwise, the output end of the AND gate D19 outputs a second enabling signal for the output end and the input end of the transmission gate D18 to be disconnected from each other. When the output end and the input end of the transmission gate D18 are connected to each other, voltage division is performed on a voltage difference between a high bias voltage (such as 5 V) and a low bias voltage (such as 0 V), by means of the first voltage division circuit formed by the resistor R17 and the resistor R25, for example, resistance values of the resistor R17 and the resistor R25 being equal.

If the first voltage division circuit does not suffer ground fault interference, the first voltage division circuit inputs a sampled voltage of 2.5 V to the transmission gate D18 via the resistor R56, and then the sampled voltage of 2.5 V is output from the transmission gate D18 to the first comparator N22 and the second comparator N22. For example, a tolerance upper limit threshold value of the first comparator is 2.75 V, and a tolerance lower limit threshold value of the second comparator is 2.25 V; tolerance lower limit threshold value < 2.5 V < tolerance upper limit threshold value, so that the first comparator and the second comparator output a second control signal.

Alternatively, the first voltage division circuit suffers ground fault interference; the resistor R314 that limits current is connected to a grounding end, and the first voltage division circuit may have a sampled voltage greater than 2.75 V (for example, encountering CAN high-voltage line ground fault interference) or a sampled voltage less than 2.25 V (for example, encountering CAN low-voltage line ground fault interference), so that, by means of inputting the sampled voltage to the first comparator and the second comparator, one of the first comparator and the second comparator is caused to output a second control signal. It should be understood that the capacitor C151 connected to the first voltage division circuit can filter out an AC component.

Furthermore, the first control signal and the second control signal may be input to the fault judgment module 240 to execute further fault judgment.

In other examples, the fault judgment module 240 comprises an integrator, one end of the integrator being connected to the output end of the first comparator, the output end of the second comparator and the CAN controller, and the other end of the integrator being connected to a high bias voltage. In the example in Fig. 3, the integrator comprises a capacitor C147 and a resistor R35.

It should be understood that, in a fault judgment period, the integrator performs integration at least according to a first current corresponding to the first control signal, to obtain a feedback voltage that indicates a ground fault index, the fault judgment period at least comprising a duration period of the first control signal.

Furthermore, in the fault judgment period, the integrator may perform integration according to the first current corresponding to the first control signal, and perform integration according to a second current corresponding to the second control signal, to obtain a feedback voltage that indicates a ground fault index, the fault judgment period at least comprising the duration period of the first control signal and a duration period of the second control signal.

It should be understood that a first enabling signal indicated by the sampled signal corresponds to period t1 - t2, period t3 - t4 and period t5 - t6, that is, corresponding to a duration period of the first control signal. A second enabling signal corresponds to period t2 - t3 and period t4 - t5, that is, corresponding to a duration period of a second control signal.

For example, a fault judgment period before T0 is within period t1 - t5. Specifically, in period t1 - t2, an integration value of period t1 - t2 is obtained by means of the integrator integrating a first circuit of the first control signal. It can be seen that, during the integration process of period t1 - t2, an integration value gradually decreases, approaching a ground fault index threshold value Qth.

Furthermore, in period t2 - t3, continuing, an integration value of period t2 - t3 is obtained by means of the integrator integrating a second circuit of the second control signal. It can be seen that, during the integration process of period t2 - t3, an integration value gradually increases, diverging from the ground fault index threshold value Qth.

Specifically, in period t3 - t4, continuing, an integration value of period t3 - t4 is obtained by means of the integrator integrating the first circuit of the first control signal. It can be seen that, during the integration process of period t3 - t4, an integration value gradually decreases, approaching a ground fault index threshold value Qth.

Furthermore, in period t4 - t5, continuing, an integration value of period t4 - t5 is obtained by means of the integrator integrating a second circuit of the second control signal. It can be seen that, during the integration process of period t4 - t5, an integration value gradually increases, diverging from the ground fault index threshold value Qth.

As shown in Fig. 4, in a fault judgment period before T0, a curve of integration values reaches the ground fault index threshold value Qth and below; therefore, the CAN controller deems that the first control signal indicating grounding of the CAN bus has sufficient influence within this period, and thus judges that a ground fault has occurred. That is, if in a fault judgment period before T0, a curve of integration values does not reach the ground fault index threshold value Qth and below, then the CAN controller deems that the first control signal indicating grounding of the CAN bus has insufficient influence within this period, and thus judges that a ground fault has not occurred.

Furthermore, in a period before T0, since a signal of the CAN bus in the dominant state has not been sampled, the obtained sampled voltage is deemed insufficiently accurate; therefore, an integration value of the integrator in a period after T0 does not change, that is, does not affect the judgment of the ground fault.

As shown in Fig. 4, in the dimensions of the high bias voltage (for example, a high bias voltage VCC shown in Fig. 4) and a low bias voltage (for example, a ground voltage GND shown in Fig. 4), if a voltage that indicates the ground fault index is less than a fault threshold value before time T0 (that is, in a fault judgment period), then the CAN controller 25 judges that the CAN bus has a ground fault, and if the voltage that indicates the ground fault index in said dimensions is higher than the fault threshold value, then the CAN controller 25 judges that the CAN bus does not have a ground fault; that is, although a sampled voltage exhibits a voltage characteristic of a recessive state in the fault judgment period, such a voltage characteristic may be due to other interference or another fault, and the fault threshold value here may be preset according to experience, and when a voltage that indicates the ground fault index Qth is higher than the fault threshold value, the CAN controller 25 does not judge same to be a ground fault.

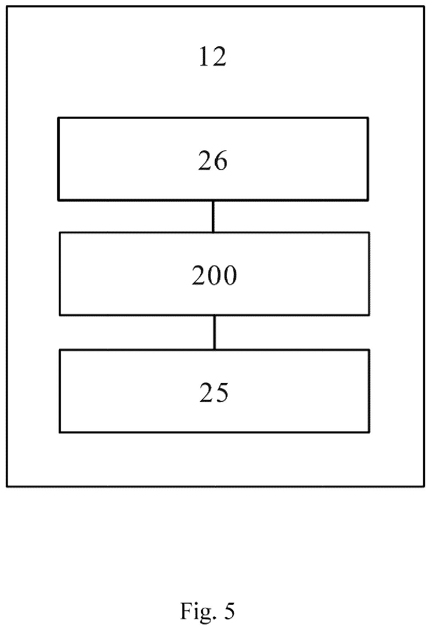

Fig. 5 shows a CAN bus device 12 according to another embodiment of the present application. The CAN bus device 12 comprises a CAN controller 25, the CAN transceiver 26, and the fault detection system 200 shown in Fig. 2.

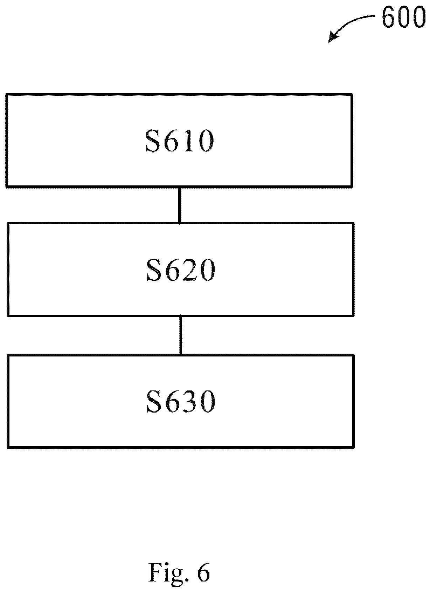

Furthermore, Fig. 6 shows a fault detection method 600 of another embodiment of the present application. The fault detection method 600 may be executed by the fault detection system 200; specifically, the fault detection method 600 comprises:
S610: Acquiring a sent logic signal and a received logic signal of a CAN transceiver.

It should be understood that the first sampling module 210 may execute step S610; for example, the first sampling module 210 is connected between the CAN transceiver and the CAN controller. The first sampling module 210 may be a digital circuit such as a logic gate; the logic gate may detect level states of a sent logic signal and a received logic signal, and based on said level states, judge a level state when the sent logic signal and the received logic signal both indicate that the CAN bus is in the dominant state, and the logic gate outputs a first enabling signal according to when the sent logic signal and the received logic signal satisfy such a level state. In addition, when the sent logic signal and the received logic signal satisfy such a level state, a second enabling signal, which is different to the first enabling signal, is output.

S620: When the sent logic signal and the received logic signal both indicate that the CAN bus is in a dominant state, detecting whether a sampled voltage between a ground wire and the CAN bus matches a first reference voltage of the CAN bus in a recessive state.

It should be understood that the second sampling module 220 may execute acquisition of the sampled voltage, one end of the second sampling module 220 being connected between a ground wire and the CAN bus, and the other end outputting the sampled voltage. The second sampling module may comprise a first voltage division circuit that is arranged between a high bias voltage and a low bias voltage, and a voltage division ratio of the first voltage division circuit is determined by means of a first reference voltage and a difference between the high bias voltage and the low bias voltage. Generally, the second sampling module may be an analog detection circuit; when an input voltage of the analog detection circuit changes, an output voltage also changes, so that a changed sampled voltage output when the CAN bus is grounded is detected. The analog detection circuit may be the first voltage division circuit.

It should further be understood that the detection module 230 may execute step S620; the detection module 230 is connected to the first sampling module 210 and the second sampling module 220, and used for detecting whether the sampled voltage matches a first reference voltage of the CAN bus in a recessive state in response to the first enabling signal. Generally, the detection module 230 may be a comparison circuit such as a comparator and a control circuit; the comparison circuit is used for determining by comparison a relationship between magnitudes of the sampled voltage and the first reference voltage, and the control circuit is used for controlling, in response to the first enabling signal or the second enabling signal, the timing of comparison processing performed by the comparison circuit, so as to output a detection result of a mismatch between the sampled voltage and the first reference voltage.

S630: When the sampled voltage and the first reference voltage do not match, converting a detection result into a ground fault index of the CAN bus.

It should be understood that the fault judgment module 240 may execute step S630; the fault judgment module 240 is connected to the detection module 230, and used for converting a detection result into a ground fault index of the CAN bus when the sampled voltage and the first reference voltage do not match. Generally, the fault judgment module may be an analog circuit or a digital circuit, that is, the detection result is digitally processed using a digital circuit, or the detection result is processed non-linearly using an analog circuit, to obtain a ground fault index.

In an embodiment of the present application, when a sent logic signal and a received logic signal both indicate that a CAN bus is in a dominant state, compared with being in a recessive state, the CAN transceiver is in a low impedance state, and an influence of the recessive state on a ground fault is eliminated as much as possible. In addition, when the CAN bus encounters a ground fault, a sampled voltage between the ground wire and the CAN bus is affected, presenting the reference voltage corresponding to the dominant state; therefore, when the CAN bus is in the dominant state, a mismatch with a first reference voltage of the CAN bus in the recessive state is detected, and thus the detection result can be converted into a ground fault index of the CAN bus to reliably and efficiently perform ground fault judgment, thereby improving efficiency and reliability of fault detection.

So far, specific embodiments of the present subject matter have been described. Other embodiments are within the scope of the appended claims. In some cases, the actions recited in the claims may be performed in a different order and still achieve desired results. In addition, the processes depicted in the drawings do not necessarily require the specific order shown or a sequential order to achieve the desired results. In certain implementations, multitasking and parallel processing may be advantageous.

It must further be explained that the terms "comprise" and "include", or any other variant thereof, are intended to cover non-exclusive inclusion, so that a process, method, commodity or device which comprises a series of key elements does not comprise these key elements alone, but also comprises other key elements which are not listed explicitly, or also comprises intrinsic key elements of this process, method, commodity or device. In the absence of further restrictions, a key element defined by the statement "comprises a..." does not exclude the existence of another identical key element in the process, method, commodity or device which comprises the key element.

Various embodiments in the description are all described in a progressive manner, and the same or similar parts across the various embodiments can make reference to each other. The emphasis of each embodiment is to describe points of difference to other embodiments. In particular, for the system embodiments, since basically similar to the method embodiments, the descriptions are relatively simple. For relevant details, please refer to the part of the description of the method embodiments.

The above are merely embodiments of the present application, which are not intended to limit the present application. For a person skilled in the art, various modifications and changes to the present application are possible. Any amendments, equivalent substitutions or improvements, etc. made within the spirit and principles of the present application shall be included in the scope of the claims thereof.

## Claims

1. A fault detection system, **characterized by** comprising:
a first sampling module (210), which is connected between a CAN transceiver and a CAN controller, and is used for acquiring a sent logic signal and a received logic signal of the CAN transceiver, and when the sent logic signal and the received logic signal both indicate that a CAN bus is in a dominant state, outputting a first enabling signal that indicates a sampling result;
a second sampling module (220), one end of the second sampling module (220) being connected between a ground wire and the CAN bus, and the other end outputting a sampled voltage;
a detection module (230), which is connected to the first sampling module (210) and the second sampling module (220), and is used for detecting whether the sampled voltage matches a first reference voltage of the CAN bus in a recessive state in response to the first enabling signal; and
a fault judgment module (240), which is connected to the detection module (230), and is used for converting a detection result into a ground fault index of the CAN bus when the sampled voltage and the first reference voltage do not match.

2. The fault detection system as claimed in claim 1, **characterized in that** the first sampling module (210) comprises an AND gate, a first input end and a second input end of the AND gate being respectively used for receiving the sent logic signal and the received logic signal, and when the sent logic signal and the received logic signal both indicate that the CAN bus is in the dominant state, the output end of the AND gate outputting a first enabling signal that indicates a sampling result.

3. The fault detection system as claimed in claim 2, **characterized in that** when one of the sent logic signal and the received logic signal indicates that the CAN bus is in the recessive state, the output end of the AND gate outputs a second enabling signal, and the second enabling signal indicates that the detection module (230) is prohibited from executing detection.

4. The fault detection system as claimed in claim 1, **characterized in that** the second sampling module (220) comprises a first voltage division circuit, one end of the first voltage division circuit being connected between a ground wire and the CAN bus, the other end being connected to a high bias voltage, the first voltage division circuit outputting the sampled voltage, and a voltage division ratio of the first voltage division circuit being provided between the first reference voltage and the high bias voltage.

5. The fault detection system as claimed in claim 1, **characterized in that** the detection module (230) comprises a transmission gate and a comparator, a control end of the transmission gate being connected to an output end of the first sampling module (210), an input end of the transmission gate being connected to an output end of the second sampling module (220), and used for receiving the sampled voltage, an output end of the transmission gate being connected to a first input end of the comparator, a second input end of the comparator receiving a tolerance threshold value of the first reference voltage, and an output end of the comparator being connected to the fault judgment module (240);
when the control end receives the first enabling signal, the output end and the input end of the transmission gate are connected to each other.

6. The fault detection system as claimed in claim 5, **characterized in that** the comparator comprises a first comparator and a second comparator, a first input end of the first comparator and a first input end of the second comparator both being connected to the output end of the transmission gate, and used for receiving the sampled voltage, a second input end of the first comparator receiving a tolerance upper limit threshold value of the first reference voltage, and a second input end of the second comparator receiving a tolerance lower limit threshold value of the first reference voltage;
when the sampled voltage is greater than the tolerance upper limit threshold value, the output end of the first comparator outputs a first control signal, which indicates that the sampled voltage and the first reference voltage do not match, to the fault judgment module (240), or when the sampled voltage is less than the tolerance lower limit threshold value, the output end of the second comparator outputs a first control signal, which indicates that the sampled voltage and the first reference voltage do not match, to the fault judgment module (240).

7. The fault detection system as claimed in claim 6, **characterized in that** the CAN bus comprises a high-voltage line and a low-voltage line, the tolerance upper limit threshold value is less than a second reference voltage of the high-voltage line in the dominant state, and the tolerance lower limit threshold value is greater than a second reference voltage of the low-voltage line in the dominant state.

8. The fault detection system as claimed in claim 6, **characterized in that** the fault judgment module (240) comprises an integrator, one end of the integrator being connected to the output end of the first comparator, the output end of the second comparator and the CAN controller, and the other end of the integrator being connected to a high bias voltage; and
in a fault judgment period, the integrator performs integration at least according to a first current corresponding to the first control signal, to obtain a feedback voltage that indicates a ground fault index, the fault judgment period at least comprising a duration period of the first control signal.

9. The fault detection system as claimed in claim 8, **characterized in that**, in the fault judgment period, the integrator performs integration according to the first current corresponding to the first control signal, and performs integration according to a second current corresponding to the second control signal, to obtain a feedback voltage that indicates a ground fault index, the fault judgment period at least comprising the duration period of the first control signal and a duration period of the second control signal.

10. The fault detection system as claimed in claim 5, **characterized in that** the fault detection system further comprises:
a driving module, which is connected to the CAN transceiver and is used for enhancing a driving current of the CAN transceiver; and
a management module, which is connected to the detection system and is used for adjusting the tolerance threshold value according to the driving current.

11. A fault detection method, **characterized by** comprising:
acquiring a sent logic signal and a received logic signal of a CAN transceiver;
when the sent logic signal and the received logic signal both indicate that a CAN bus is in a dominant state, detecting whether a sampled voltage between a ground wire and the CAN bus matches a first reference voltage of the CAN bus in a recessive state; and
when the sampled voltage and the first reference voltage do not match, converting a detection result into a ground fault index of the CAN bus.

12. A CAN bus device, **characterized by** comprising:
a CAN controller (25);
a CAN transceiver (26); and
the fault detection system (200) as claimed in any one of claims 1-10.
